# EUROPEAN PATENT APPLICATION

(11) **EP 0 670 599 A1**
(43) Date of publication of application: **06.09.1995**
(21) Application number: 95300772.1
(22) Date of filing: 08.02.1995
(51) Int. Cl.: H01L 23/66, H01L 23/495

(54) **An integrated circuit package with improved high frequency performance**

(30) Priority: 28.02.1994 US 202316
(71) Applicant: Hewlett-Packard Company, Palo Alto, California 94304 (US)
(72) Inventor: Niedzwiecki, Antoni C., San Jose CA 95129 (US)
(74) Representative: Powell, Stephen David

(57) **Abstract**

A package using plastic as the insulating packaging material (43) for a semiconductor device (51) and having an air pocket in which the device resides creates a surface mountable integrated circuit ("IC") with very low parasitic inductance and capacitance suitable in high frequency applications. The package comprises a conductive substrate (41) part of which is surrounded by the packaging material (43), the semiconductor device (51) being coupled to the substrate in a non-surrounded region and having a cover (45) supported by the packaging material (43) but not contacting the semiconductor device itself.

## Description

The present invention is generally in the field of packages for semiconductor devices and particularly in the field of packages for high frequency semiconductor devices.

Semiconductor devices are typically packaged in either ceramic or plastic. Known plastic packages consist of a metal lead frame and a molded volume of plastic material which encapsulates part of the lead frame. A molding operation is performed after the semiconductor device is attached to the metal lead frame, the molding operation encapsulating the lead frame and its attached device. The plastic material is in direct contact with the device. The lead frames are usually die stamped. Typically, a single stamping operation forms a plurality of lead frames, which remain attached to one another. After the molding operation, the completed devices are separated. Metal terminals protrude from the plastic body of the device and allow it to be connected to an electronic circuit. Preparing the finished device for surface mounting usually requires special forming of the lead frame. Assembly steps involving high temperatures, if any, are performed before the molding operation. This avoids exposing the encapsulating plastic to high temperatures.

Both the metal leads and the plastic material used for the package degrade the performance of the semiconductor device. This degradation is especially severe at high frequencies above 5GHz and in semiconductor devices having field effects transistors ("FETs"). FETs are particularly susceptible to parasitic capacitances and inductances resulting from direct contact with the plastic material. Plastic packaging materials also have a high thermal resistance which limits the amount of power which they can safely dissipate.

Where high frequency performance is crucial, ceramic packages with an internal air gap have been constructed and used. Although the performance of these ceramic packages, made from aluminum oxide or beryllium oxide, is very good, they are also very expensive. Attempts to make such packages less expensive have succeeded only at the cost of reducing the reliability and performance of the packages to an unacceptably low level.

A need exists for an inexpensive semiconductor device package which will provide the same high frequency performance as ceramic packages with the cost and simple processing requirements of a plastic semiconductor device package.

In a preferred embodiment, the present invention comprises a method for fabricating an inexpensive package for a semiconductor device mounted on a lead frame using a plastic material and the package which results from practicing this method. Herein all references to the term "semiconductor device" are intended to include any type of electronic component fabricated using a semiconductor material, including diodes, transistors, integrated circuits ("ICs"), resistors, etc. The method leaves an air gap over the device, which improves its high frequency performance. Packages made using this method can be surface mounted and have improved temperature dissipation characteristics, as well as their improved performance at high frequency. A package constructed according to the teachings of the present invention has many of the advantages of a ceramic package but is significantly less expensive to make.

The present invention will now be described in detail with reference to the figures listed and described below.
Fig. 1 is a cross section of a known plastic IC package;
Fig. 2 is a cross section of a known plastic IC package with a partially exposed lead frame;
Fig. 3 is a cross section of a known ceramic IC package;
Fig. 4 is a top view of a first embodiment of the present invention;
Fig. 5 is a first cross section of the first embodiment of the present invention, taken along the line A-A in Fig. 4; and
Fig. 6 is a second cross section of the first embodiment of the present invention, taken along the line B-B in Fig. 4.

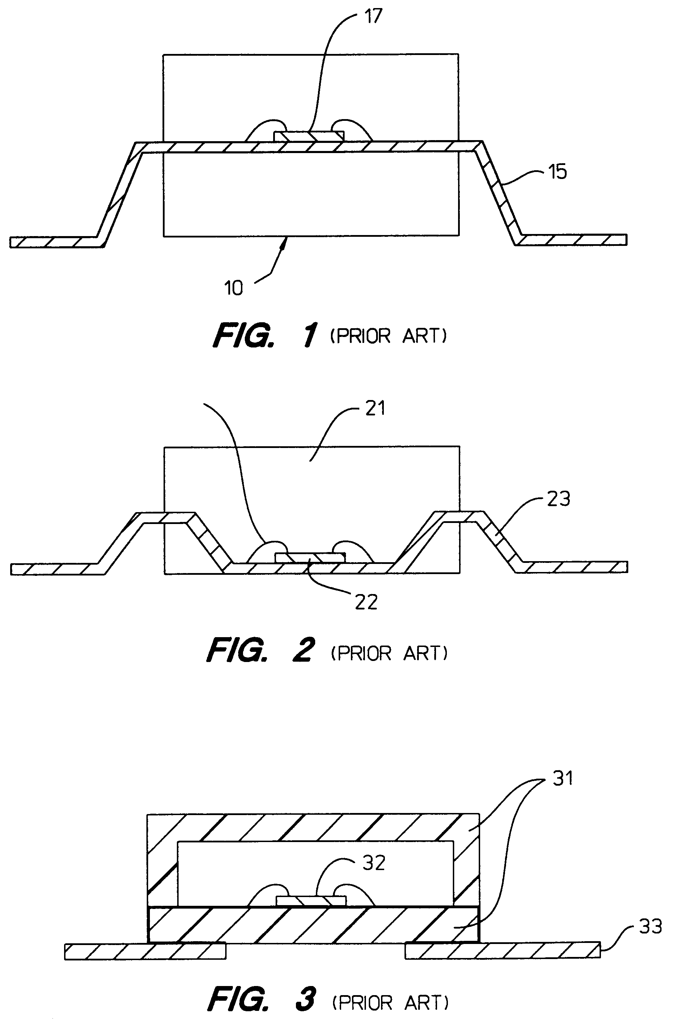

Fig. 1 is a cross section of a known type of plastic package for a semiconductor device. Package 10 is formed of a plastic material which completely imbeds lead frame 15 and semiconductor device 17. The leads of lead frame 15 must be bent so that the completed device may be surface mounted. Plastic package 10 contacts semiconductor device 17. Fig. 2 is a cross section of a related known type of plastic package for a semiconductor device. Again, plastic package material 21 imbeds both semiconductor device 22 and lead frame 23. However, the underside of lead frame 23 is partially exposed. This permits more heat dissipation than from the package shown in Fig. 1. However, this design requires even more extreme bending and manipulation of the lead frame so that it can be surface mounted. Fig. 3 is a cross section of a known type of ceramic package for a semiconductor device. Unlike the packages shown in Figs. 1 and 2, ceramic packaging material 31 does not contact semiconductor device 32. This permits high frequency operation. However, the ceramic material must be coated with a conductive metal 34 so that semiconductor device 32 can be electrically coupled to lead frame 33. Also, as the ceramic package is typically fashioned in two pieces, an expensive assembly step is needed to create a finished usable device.

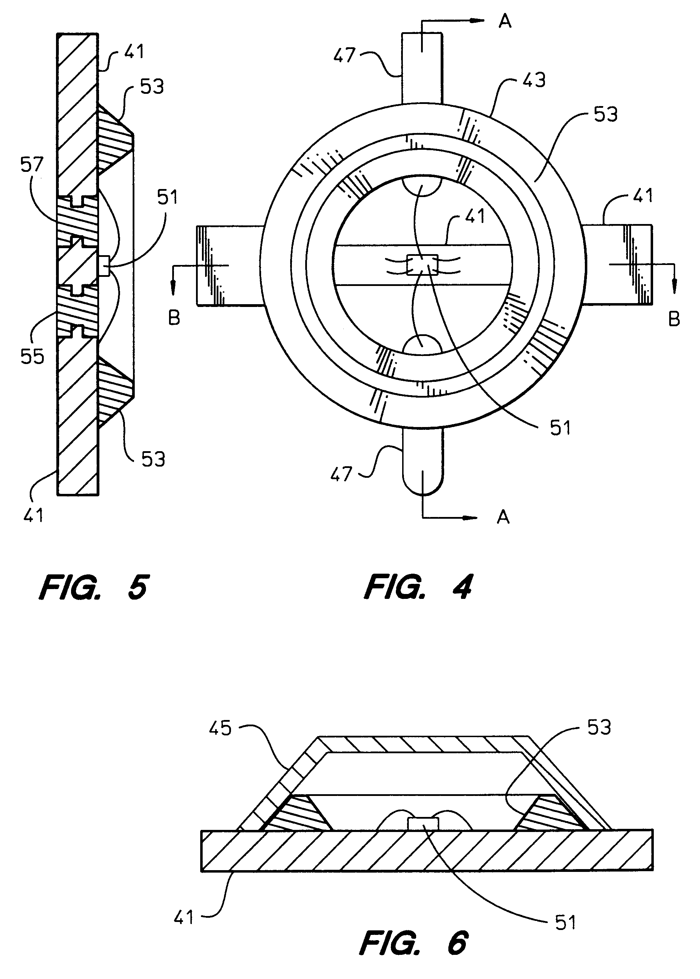

The first embodiment of the present invention is shown in Figs. 4, 5, and 6. Fig. 4 is a top view of this first embodiment, Fig. 5 is a cross section of this embodiment, taken through line A-A in Fig. 4, and Fig. 6 is another cross section of the same embodiment, taken through line B-B in Fig. 4.

As shown in Fig. 4, this embodiment of the present invention is comprised of lead frame 41, plastic casing 43, top cover 45 and semiconductor device 41. As shown in both Figs. 5 and 6, lead frame 41 is stamped from a thin sheet of metal and is flat. Plastic casing 43 forms a ring around semiconductor device 41. A top cover 45 is placed and sealed over ring 41 after semiconductor device 41 has been attached to lead frame 41.

Fig. 5 shows how input/output leads 47 have a flange, which improves the integrity of the completed package.

To create a package according to the teachings of the present invention, lead frame 41 is stamped or otherwise fabricated as a flat piece of conductive metal. A plastic material is then flowed around lead frame 41, flowing through holes 51 in lead frame 41(see Fig. 5) and then formed to create packaging material ring 53. This operation leaves the undersurface of lead frame 41 exposed and in the same plane as the plastic material. Both Ryton and Ultem, respectively manufactured by Phillips 66 and GE Plastics, could be used to form the package described herein. Semiconductor device 43 is then mounted on top of lead frame 41 and coupled to the lead frame's terminals.

After ring 53 is completed and all electrical connections between lead frame 41 and device 43 made, cover 55 is placed over ring 53 and cemented or welded in place. This process produces a package wherein the semiconductor device does not contact the packaging plastic material and where input/output lead length, as well as common lead length is kept to a minimum.

A semiconductor device assembled in a package made according to the teachings of the present invention does not come in contact with the insulating material that makes up the package. This eliminates the performance degradation that occurs in conventional packages, where the semiconductor device does contact the insulating material. The fact that the semiconductor device is housed in an air cavity permits operation at high frequencies up to at least 18 GHz.

As the undersurface of the device's lead frame is exposed and flat, no lead forming is necessary to prepare the package for surface mounting. This configuration also creates a shorter electrical path between the semiconductor device inside the package and the external circuitry than occurs when using conventional packages. The shorter pathway has lower parasitic inductance, particularly lower common lead inductance than found in conventional packages. Low parasitic inductance is a critical design parameter for high frequency operation.

The exposed undersurface of the lead frame permits the direct attachment of a heat sink, a valuable capability for devices which dissipate a large amount of power.

## Claims

1. A package for a semiconductor device comprising:
conductive lead frame (41) having a top and bottom side and at least a first and second lead(47), the semiconductor device(51) being mounted on the conductive lead frame(41) and being coupled to the first and second leads(47);
packaging material which is flowed around the lead frame and which forms a raised structure(53) around the semiconductor device(51), the material leaving the bottom side of the lead frame(41) exposed and not contacting the semiconductor device; and
a cover(45) attached to the raised structure(53) and not contacting the semiconductor device(51).

2. A method for fabricating a low cost, low parasitic inductance and low parasitic capacitance package for a semiconductor device, the method comprising the steps of:
forming a conductive lead frame(41) having an upper and lower surface and at least a first and second lead(47);
flowing a packaging material(43) around the lead frame, the packaging material(43) forming a raised structure(53) around the lead frame(41) and leaving the lower surface of the lead frame(41) exposed;
attaching the semiconductor device(51) to the conductive lead frame(41) and coupling it to at least the first and second lead(47); and
attaching a cover(45) to the raised structure(53), the cover not contacting the semiconductor device(51) and forming a sealed air pocket over it.

3. A package for an electronic device comprising;
conductive substrate(41);
packaging material(43) surrounding a predetermined portion of the conductive substrate(41), the electronic device(51) coupled to the conductive substrate(41) in a area devoid of the packaging material(43); and
a cover(45) mounted over the electronic device(51), the cover being supported by the packaging material(43) and not contacting the electronic device(51).

4. The package of claim 3 wherein the conductive substrate(41) has a front and back surface, the back surface remaining exposed after the packaging material(43) has surrounded the substrate(41) and the electronic device(51) is coupled to front surface of the conductive substrate(41).

5. The package of claim 3 wherein the electronic device(51) operates at a frequency at or above 1 GHz and is completely surrounded by the packaging material(43) and the cover(45) but is not in physical contact with the packaging material(43)and cover(45).

6. The package of claim 5 wherein the packaging material(43) is flowed into place around and over the conductive substrate(41) prior to coupling the electronic device(51) to the conductive substrate (41).

7. The package of claim 3 wherein the packaging material(43) comprises a plastic packaging material.
